# EUROPEAN PATENT SPECIFICATION

(11) **EP 0 418 912 B1**
(45) Date of publication and mention of the grant of the patent: **22.11.1995**
(21) Application number: 90118181.8
(22) Date of filing: 21.09.1990
(51) Int. Cl.: H01L 27/02

(54) **Semiconductor integrated circuit device**
Integrierte Halbleiterschaltungsanordnung
Dispositif de circuit intégré semi-conducteur

(30) Priority: 22.09.1989 JP 245296/89; 22.11.1989 JP 303805/89
(43) Date of publication of application: 27.03.1991
(73) Proprietor: KABUSHIKI KAISHA TOSHIBA, Kawasaki-shi, Kanagawa-ken 210 (JP); TOSHIBA MICRO-ELECTRONICS CORPORATION, Kawasaki-ku, Kawasaki-shi (JP)
(72) Inventor: Ichikawa, Yoshihiro, c/o Intellectual Property Div, Minato-ku, Tokyo 105 (JP); Watanabe, Seiji, c/o Intellectual Property Div., Minato-ku, Tokyo 105 (JP); Saigo, Takashi, c/o Intellectual Property Div., Minato-ku, Tokyo 105 (JP); Umetsu, Tsutomu, c/o Intellectual Property Div., Minato-ku, Tokyo 105 (JP)
(74) Representative: Lehn, Werner, Dipl.-Ing.

(56) References cited:
- EP-A- 0 181 059
- JP-A- 1 196 137
- IEEE JOURNAL OF SOLID-STATE CIRCUITS, vol. SC-21, no. 2, April 1986, New York, US, pp. 240-246 ; E.G. FRIEDMAN & S. POWELL : "Design and Analysis of a Hierarchical Clock Distribution System for Synchronous Standard Cell/Macrocell VLSI"

## Description

The present invention relates to a semiconductor integrated circuit device.

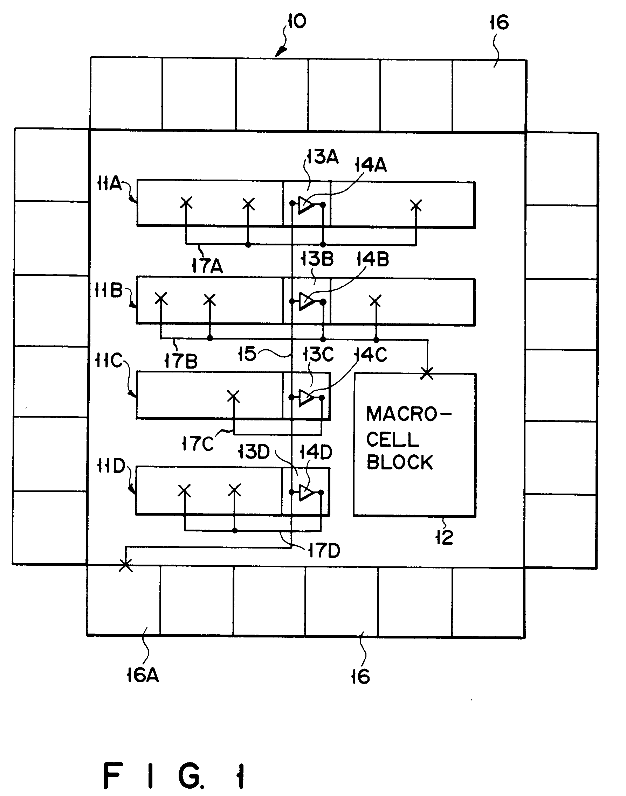

A prior art example of a semiconductor integrated circuit having a plurality of cell rows is shown in Fig. 1.

In Fig. 1, the numeral 10 indicates a chip body, 11A through 11D cell rows each comprising a plurality of standard cells, 12 a macrocell block, 13A through 13D signal amplifiying cells provided in respective cell rows 11A through 11D and located in a line in the direction perpendicular to the cell rows, that is, in the vertical direction on the figure, 14A through 14D signal amplifiers provided in respective signal amplifying cells 13A through 13D, and 15 a cell column wiring layer which is thicker in width than a standard wiring layer formed in the circuit, and which interconnects the inputs of the signal amplifiying cells 13A through 13D of the cell rows 11A through 11D.

Numeral 16 indicates I/O (input/output) cells located on the periphery of the chip body, and 16A a clock driver cell acting as an input of a clock signal. The clock signal amplified by the cell 16A is supplied to the inputs of the signal amplifiers 14A through 14D of the signal amplifying cells 13A through 13D.

Outputs of the signal amplifying cells 13A through 13D, that is outputs of the signal amplifiers 14A through 14D, are connected via respective cell-row wiring layers 17A through 17D to a circuit (not shown), for example, a flip flop circuit, in a standard cell (not shown) in the respective cell rows 11A through 11D. The cell-row wiring layers are of a width of the standard wiring layer formed in the circuit.

In the semiconductor integrated circuit device described above, there is a variation between cell rows 11A through 11D with respect to the load capacity (marked with "x" in Fig. 1) of each cell row. The load capacity marked with "x" corresponds to the gate capacity of, for example, a flip flop circuit (not shown) in the standard cell. There is also a variation between the cell rows with respect to the length of the cell-row wiring layer. These variations cause a clock skew in which the output clock signals of the signal amplifying cells in the cell rows have a phase difference between the cell rows 11A through 11D. A smaller clock skew is preferable. However, the clock skew increases by increased size of circuit, increased load capacity, its variation.

From JP-A-1 196 137 a semiconductor integrated circuit device is known, comprising a plurality of cell rows and a plurality of signal amplifying cells respectively provided on said cell rows and aligned with each other in the column direction. A plurality of load capacitance adjusting cells is provided on each of said cell rows, for constituting capacity components. A plurality of cell row wiring layers respectively provided along said cell rows each connect an output terminal of a respective signal amplifying cell to the load capacitance adjusting cells of the respective cell row.

The object of the present invention is to provide a semiconductor integrated cicuit device having a reduced clock skew.

The object is solved by a semiconductor integrated cicuit device according to claim 1 which shows, in addition to a semiconductor integrated circuit device known from JP-A-1 196 137, the features that the load capacitance adjusting cells are aligned along the column direction and that the capacities corresponding to the cell row wiring layers are the same for different rows.

The subclaims show advantageous further developments of the invention. Especially, the semiconductor integrated circuit device comprises a further cell-column wiring layer for interconnecting the ouput terminals of the signal amplifying cells as it is already known from EP-A-0 181 059.

This invention can be more fully understood from the following detailed description when taken in conjunction with the accompanying drawings, in which:
Fig. 1 is a pattern top view of a prior art semiconductor integrated circuit device;
Fig. 2 is a pattern top view of a semiconductor integrated circuit device;
Fig. 3 is a pattern top view of another semiconductor integrated circuit device;
Fig. 4 is a pattern plan view showing a semiconductor integrated circuit device of an embodiment according to the present invention;
Fig. 5 is a pattern plan view showing a structure of the adjusting cell having load capacity [1];
Fig. 6 is a pattern plan view showing a structure of the adjusting cell having load capacity [2], in which the gate length is 2L and the gate width is W;
Fig. 7 is a pattern plan view showing a structure of the adjusting cell having load capacity [0], in which the gate width is W, and a gate electrode is not provided and thus the gate length is 0;
Fig. 8 is a pattern plan view showing a semiconductor integrated circuit device of a further embodiment according to the present invention; and
Fig. 9 is a pattern plan view showing a semiconductor integrated circuit device of a further embodiment according to the present invention.

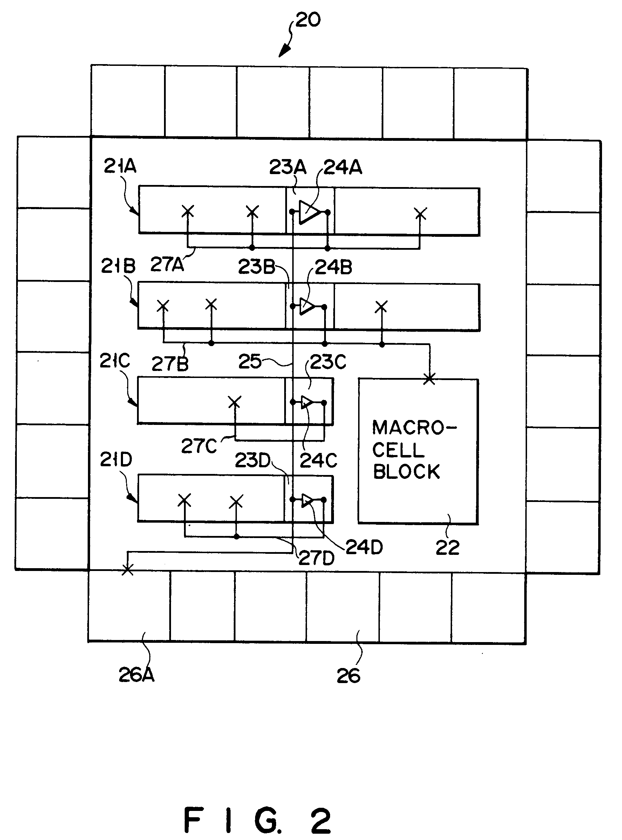

With reference to drawings, an embodiment of a semiconductor integrated circuit device will be explained hereinafter. Fig. 2 is a pattern top view of an embodiment of a semiconductor integrated circuit device.

In Fig. 2, the numeral 20 indicates a chip body, 21A through 21D respective cell rows each comprising a plurality of standard cells, 22 a macrocell block, 23A through 23D respective signal amplifying cells provided in respective cell rows 21A through 21D and located in a line in the direction perpendicular to the cell rows, that is, in the vertical direction on the figure, 24A through 24D respective signal amplifiers provided in the signal amplifying cells 23A through 23D, and 25 a cell-column wiring layer which interconnects the inputs of the signal amplifying cells 23A through 23D of the cell rows 21A through 21D.

The cell-column wiring layer 25 has a width determined with respect to the size of the circuit device and the load capacity (marked with x in the figure) of each cell row. For example, where the number of cell rows increases with an increase of the size of circuit, the resistance of the cell-column wiring increases and, thus, time delay in signal transmission increases. In order to suppress such increase, the width of the cell-column wiring layer is set to be larger, thereby allowing wiring resistance to be reduced.

The placement of the signal amplifying cells 23A through 23D in a line in the vertical direction is because that such placement causes the cell-column wiring layer 25 to become the minimum length and the impedance to be the minimum value.

Numeral 26 indicates I/O (input/output) cells located on the periphery of the chip body, and 26A a clock driver cell acting as an input of a clock signal. The clock signal amplified by the cell 26A is supplied to the inputs of the signal amplifiers 24A through 24D of the signal amplifying cells 23A through 23D.

Outputs of the signal amplifying cells 23A through 23D, that is, outputs of the signal amplifiers 24A through 24D, are connected via the respective cell-row wiring layers 27A through 27D to a circuit (not shown), for example, a flip flop circuit, of a standard cell in the respective cell rows 21A through 21D. The cell-row wiring layers are of a width of the standard wiring layer formed in the circuit.

In the device of Fig. 2, assuming that the load capacity in the cell 21C is [1], the load capacity in the cell 21D becomes two-fold [2], the load capacity in the cell 21A becomes three-fold [3], and the load capacity in the cell 21B becomes four-fold [4]. That is, the number of [x] in Fig. 2 represents that of load capacity. In this case, the drive ability of the amplifier 24C in the cell row 21C is set in [1], the drive ability of the signal amplifier 24D in the cell row 21D having two-fold load capacity [2] is set in two-fold [2], the drive ability of the signal amplifier 24A in the cell row 21A having three-fold load capacity [3] is set is three-fold [3], and the drive ability of the signal amplifier 24B in the cell row 21B having four-fold load capacity [4] is set in four-fold [4].

Where the variation of load capacity between cell rows are not in an integer ratio, for example, the load capacity of the cell row 21A is [2.5], the drive ability of the amplifier 24D is set in [2] or the drive ability of the amplifier 24A is set in [3].

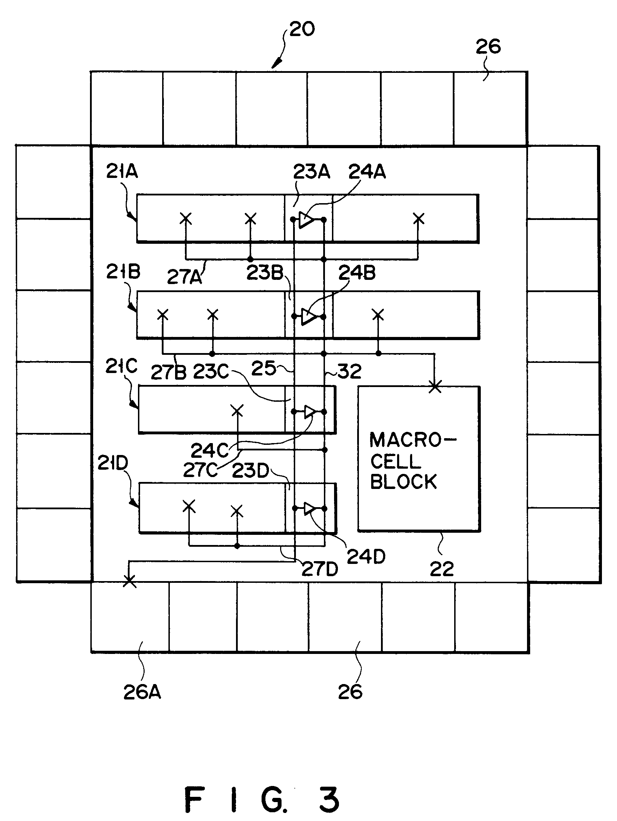

Fig. 3 is a pattern top view of another embodiment of a semiconductor integrated circuit device.

In the embodiment, a cell-column wiring layer 32 is included, which interconnects the outputs of the signal amplification cells 24A through 24D in the cell rows 21A through 21D. Other structure is substantially the same as that of the embodiment shown in Fig. 2, thus the descriptions thereof being omitted. Same portions or parts are denoted by the same reference numerals.

The selection of the width of the wiring layer 32 compensates for the unbalance, between the cell rows, in load capacity (marked with x mark) and in drive ability. The width of the wiring layer 32 is determined with respect to an increase of circuit size or a variation of load capacity between cell rows.

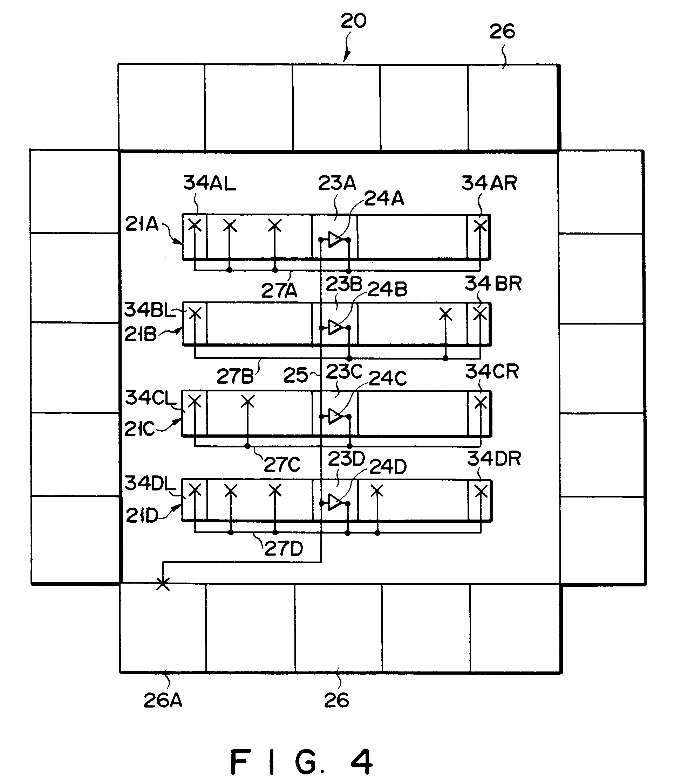

There will be described a semiconductor integrated circuit device of an embodiment according to the present invention, with reference to Fig. 4.

Fig. 4 is a pattern plan view showing a semiconductor integrated circuit device of the embodiment according to the present invention.

In the circuit device of Fig. 4, further cells 34AR through 34DR and 34AL through 34DL for adjusting the load capacity are provided, the cell-column wiring layer 25 is widened to reduce the resistance thereof to the extent that the resistance is negligible for time delay of signal transmission, and the amplifiers have the same drive ability. Other structure is substantially the same as that in the previous embodiments, thus the descriptions thereof being omitted. Same portions or parts are denoted by the same reference numerals. Macrocell block is omitted in Fig. 4 and the later described embodiments, for simplicity.

The adjusting cells 34AL and 34AR are provided on the left half portion and the right half portion of the cell rows 21A, respectively. The adjusting cells 34BL and 34BR are provided on the left half portion and the right half portion of the cell rows 21B, respectively. The adjusting cells 34CL and 34CR are provided on the left half portion and the right half portion of the cell rows 21C, respectively. Similarly, the adjusting cells 34DL and 34DR are provided on the left half portion and the right half portion of the cell rows 21D, respectively.

The adjusting cells 34AL and 34AR are connected to the output terminal of the amplifier 24A of the cell row 21A via cell-row wiring layer 27A. The adjusting cells 34BL and 34BR are connected to the output terminal of the amplifier 24B of the cell row 21B via cell-row wiring layer 27B. The adjusting cells 34CL and 34CR are connected to the output terminal of the amplifier 24C of the cell row 21C via cell-row wiring layer 27C. Similarly, the adjusting cells 34DL and 34DR are connected to the output terminal of the amplifier 24D of the cell row 21D via cell-row wiring layer 27D.

These adjusting cells are used to equalize the capacities of the cell rows 21A through 21D so that the load capacities of the amplifiers 24A through 24D are equal to each other. By doing so, the phase difference of the clock signals at the output terminals of the amplifiers 24A through 24D are significantly suppressed and, the clock skew problem is virtually eliminated.

These adjusting cells are constituted in such a manner that they have a unit capacity or several times the unit capacity, so that the designing of the semiconductor circuit device may be simplified.

There will now be described how to equalize the load capacities of the cell rows by means of the adjusting cells.

In the right half portions of the cell rows of the circuit device shown in Fig. 4, the cell rows 21B and 21D have the load capacity [1], and cell rows 21A and 21C have no load capacity. Thus, adjusting cells having the load capacity [1] are used as the adjusting cells 34AR and 34CR. On the other hand, adjusting cells having the load capacity [0] are used as the adjusting cells 34BR and 34DR. In this way, the load capacity of the right half portions of the cell rows are equalized to load capacity [1].

In the left half portions of the cell rows of the circuit device shown in Fig. 4, the cell rows 21A and 21D have the load capacity [2], the cell row 21C has the load capacity [1], and cell row 21B has no load capacity. Thus, an adjusting cell having the load capacity [2] is used as the adjusting cells 34BL, and an adjusting cell having the load capacity [1] is used as the adjusting cell 34CL. On the other hand, adjusting cells having the load capacity [0] are used as the adjusting cells 34AL and 34DL. In this way, the load capacity of the light half portions of the cell rows are equalized to load capacity [2].

As a result, the load capacities of the cell rows are equalized to [3] and, thus the phase difference of the clock signals at the output terminal of the amplifiers is effectively suppressed.

When the adjusting cells are positioned at the end portions of the cell rows, as shown in Fig. 4, the lengths of the cell rows are the same and, thus, the capacities corresponding to the lengths of the wiring layers are the same. The cells having load capacity [0] are inserted into the circuit device in order to extend the cell-row wiring layer to the ends of the cell rows.

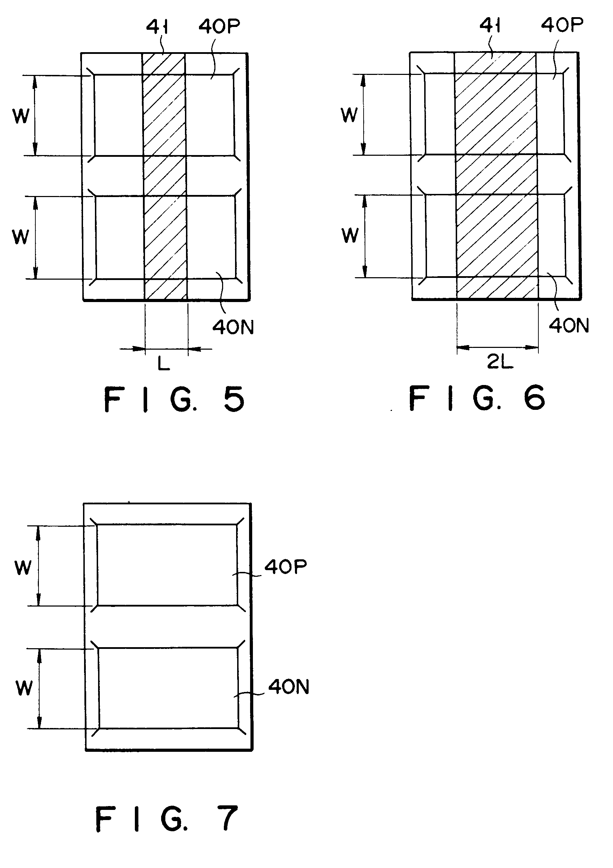

There will now be described structures of the adjusting cells with reference to Figs. 5 through 7.

Fig. 5 is a pattern plan view showing a structure of the adjusting cell having load capacity [1].

As shown in Fig. 5, the adjusting cell comprises a P channel MOS transistor 40P and an N channel MOS transistor 40N. A gate electrode 41 extends over these MOS transistors. The structure of the adjusting cell may be substantially the same as that of the input gate of a standard cell (not shown), for example, a flip flop circuit, connected to the cell-row wiring layers. By doing so, the gate capacity of the adjusting cell equals to the gate capacity of the flip flop circuit, and the adjusting cell functions as a load capacity corresponding to the gate capacity of the flip flop circuit, when the adjusting cell is used in the cell rows.

For example, when a CMOS inverter whose gate length is L and whose gate width is W is used as an input gate of a flip flop circuit, a load capacity adjusting cell shown in Fig. 5 whose gate length is L and whose gate width is W is used, so that the gate capacitance of the flip flop circuit equals to the gate capacitance of the adjusting cell.

Fig. 6 is a pattern plan view showing a structure of the adjusting cell having load capacity [2], in which the gate length is 2L and the gate width is W.

Fig. 7 is a pattern plan view showing a structure of the adjusting cell having load capacity [0], in which the gate width is W, and a gate electrode is not provided and thus the gate length is 0.

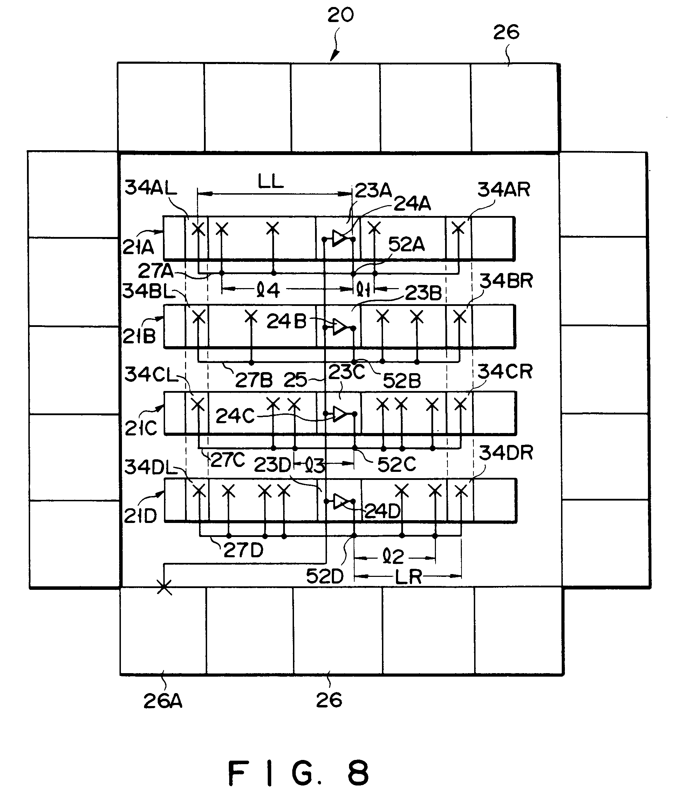

In the embodiment shown in Fig. 4, the adjusting cells are positioned at the ends of the row cells. However, the positioning of the adjusting cells is not limited thereto. For example, as shown in Fig. 8 which shows a pattern plan view showing a semiconductor integrated circuit device of a further embodiment according to the present invention, the adjusting cells may be positioned in the midst of the cell rows.

In the right half portion of the circuit device shown in Fig. 8, among the cell rows, the cell rows 21A has a standard cell which is nearest to the connecting portion 52A, and the cell row 21D has a standard cell which is furthest from the connecting portion 52D. The nearest standard cell is away from the connecting portion 52A by distance ℓ1. The furthest standard cell is away from the connecting portion 52D by distance ℓ2. The adjusting cell 34DR is positioned outside the furthest standard cell in the cell row 21D. The distance between the connecting portion 52D and the adjusting cell 34DR is LR. Other adjusting cells 34AR through 34CR are positioned at the portions in the cell rows, which corresponds to the position where the adjusting cell 34DR is provided in the cell row 21D. In this way, all the adjusting cells 34AR through 34DR are positioned at the respective positions which are far by distance LR from the respective connecting portions 52A through 52D of the amplifiers 24A through 24D with the cell-row wiring layers 27A through 27D in the cell rows 21A through 21D.

In the left half portion of the circuit device shown in Fig. 8, among the cell rows, the cell row 21C has a standard cell which is nearest to the connecting portion 52C, and the cell row 21A has a standard cell which is furthest from the connecting portion 52A. The nearest standard cell is separated from the connecting portion 52C by distance ℓ3. The furthest standard cell is away from the connecting portion 52A by distance ℓ4. The adjusting cell 34CL is positioned outside the furthest standard cell in the cell row 21C. The distance between the connecting portion 52C and the adjusting cell 34CL is LL. Other adjusting cells 34AL, 34BL, and 34DL are positioned at the portions in the cell rows, which corresponds to the position where the adjusting cell 34CL is provided in the cell row 21C. In this way, all the adjusting cells 34AL through 34DL are positioned at the respective positions which are far by distance LL from the respective connecting portions 52A through 52D of the amplifiers 24A through 24D with the cell-row wiring layers 27A through 27A in the cell rows 21A through 21D.

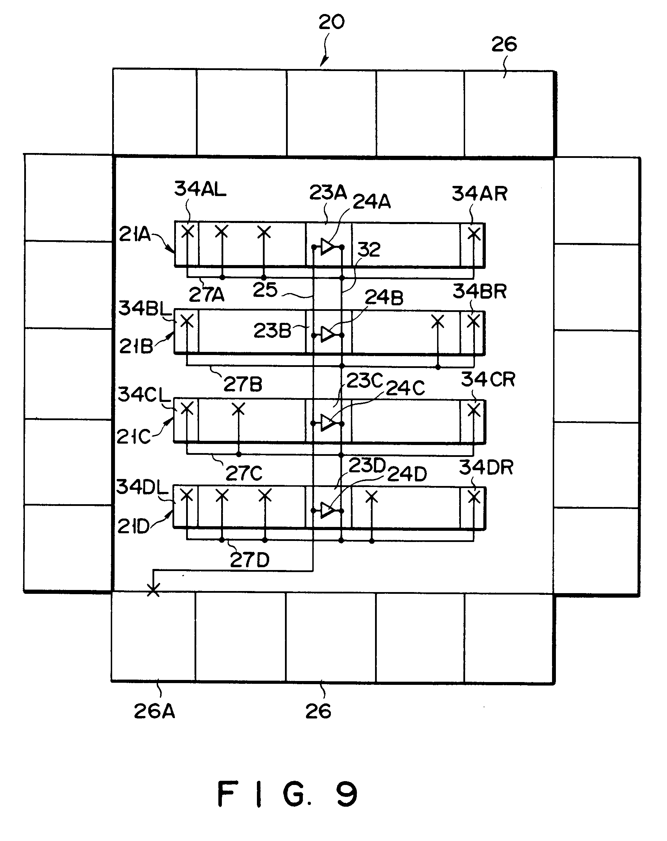

Fig. 9 shows a pattern plan view showing a semiconductor integrated circuit device of a yet further embodiment of the present invention.

In the circuit device shown in Fig. 9, the outputs of the amplifiers are interconnected by a cell-column wiring layer 32, so that the variation of the capacitance in the amplifiers are canceled to effectively reduce the generation of the phase difference of the clock signal.

Other structure is substantially the same as that in the embodiment shown in Fig. 8, thus the descriptions thereof being omitted. Same portions or parts are denoted by the same reference numerals.

A clock phase difference between the outputs of signal amplifying cells of the cell rows can be suppressed by matching the drive ability of the signal amplification cells in the cell rows with the load capacity of the corresponding cell rows. The clock phase difference is further suppressed by setting the width of the cell-column wiring layer connecting the inputs of the signal amplification cells in the cell rows in a value determined based on the circuit size or the load capacity variation. The phase difference is further suppressed by interconnecting the outputs of the signal amplification cells in the cell rows by means of a cell-column wiring layer whose width is determined based on the circuit size or the load capacity variation. Thus, a clock skew due to an increase of the circuit size, and the load capacity variation can be greatly suppressed.

According to the present invention the clock phase difference can also be suppressed by equalizing the load capacities of the cell rows using a load capacity adjusting cell.

Reference signs in the claims are intended for better understanding and shall not limit the scope.

## Claims

1. A semiconductor integrated circuit device comprising:
a plurality of cell rows (21A through 21D) each including a plurality of standard cells;
a plurality of signal amplifying cells (23A through 23D) respectively provided on said cell rows, aligned with each other in the column direction and each including a signal amplifier (24A through 24D);
a plurality of load capacitance adjusting cells (34AR through 34DR and 34AL through 34DL) provided on each of said cell rows, for constituting capacity components equalizing the load capacities of the cell rows;
a cell-column wiring layer (25) for interconnecting inputs of said signal amplifying cells; and
a plurality of cell row wiring layers respectively provided along said cell rows, each connecting an output terminal of the signal amplifying cell of the corresponding one of said cell rows to said standard cells and to said load capacitance adjusting cells provided on said corresponding cell row;
wherein said cell rows have the same length and said load capacitance adjusting cells of different cell rows are aligned with each other in the column direction so that the capacities corresponding to the lengths of the cell row wiring layers are the same.

2. A semiconductor integrated circuit device according to claim 1, further comprising:
a further cell-column wiring layer (32) for interconnecting said output terminals of said signal amplifying cells.

3. A semiconductor integrated circuit device according to claim 1 or 2, wherein said load capacitance adjusting cells are located at the ends of said cell rows.

## Patentansprüche

1. Integrierte Halbleiterschaltungseinrichtung, umfassend:
eine Vielzahl von Zellenzeilen (21A bis 21D), die jeweils eine Vielzahl von Standardzellen umfassen
eine Vielzahl von Signalverstärkungszellen (23A bis 23D), die jeweils auf den Zellenzeilen, ausgerichtet zueinander in der Spaltenrichtung und jeweils einen Signalverstärker (24A bis 24D) umfassend vorgesehen sind;
eine Vielzahl von Lastkapazitäts-Einstellzellen (34AR bis 34DR und 34AL bis 34DL), die auf jeder der Zellenzeilen vorgesehen sind, zum Bilden von Kapazitätskomponenten, die die Lastkapazitäten der Zellenzeilen ausgleichen;
eine Zellenspalten-Verdrahtungsschicht (25) zum Verbinden von Eingängen der Signalverstärkungszellen untereinander; und
eine Vielzahl von Zellenzeilen-Verdrahtungsschichten, die jeweils entlang der Zellenzeilen vorgesehen sind, die jeweils einen Ausgangsanschluß der Signalverstärkungszelle der entsprechenden Zellenzeile mit den Standardzellen und den auf der entsprechenden Zellenzeile vorgesehenen Lastkapazitäts-Einstellzellen verbinden;
wobei die Zellenzeilen die gleiche Länge aufweisen und die Lastkapazitäts-Einstellzellen von unterschiedlichen Zellenzeilen zueinander in der Spaltenrichtung ausgerichtet sind, so daß die Kapazitäten entsprechend der Länge der Zellenzeilen-Verdrahtungsschichten die gleichen sind.

2. Integrierte Halbleiterschaltungseinrichtung nach Anspruch 1, ferner umfassend:
eine weitere Zellenspalten-Verdrahtungsschicht (32) zum Verbinden der Ausgangsanschlüsse der Signalverstärkungszellen untereinander.

3. Integrierte Halbleiterschaltungseinrichtung nach Anspruch 1 oder 2,
dadurch **gekennzeichnet**, daß sich die Lastkapazitäts-Einstellzellen an den Enden der Zellenzeilen befinden.

## Revendications

1. Dispositif à circuit intégré à semi-conducteur comprenant :
plusieurs rangées de cellules (21A à 21D) chacune comprenant plusieurs cellules standard ;
plusieurs cellules d'amplification de signal (23A à 23D) disposées, respectivement, dans lesdites rangées de cellules, alignées les unes avec les autres dans la direction des colonnes et chacune incluant un amplificateur de signal (24A à 24D) ;
plusieurs cellules de réglage de capacité de charge (34AR à 34DR et 34AL à 34DL) disposées dans chacune desdites rangées de cellules, pour constituer des composantes de capacité égalisant les capacités de charge des rangées de cellules ;
une couche de câblage de colonnes de cellules (25) pour interconnecter les entrées desdites cellules d'amplification de signal ; et
plusieurs couches de câblage de rangées de cellules disposées, respectivement, le long desdites rangées de cellules, chacune connectant une borne d'entrée de la cellule d'amplification de signal de l'une correspondante desdites rangées de cellules auxdites cellules standards et auxdites cellules de réglage de capacité de charge disposées dans ladite rangée de cellules correspondante ;
dans lequel lesdites rangées de cellules ont la même longueur et lesdites cellules de réglage de capacité de charge de rangées de cellules différentes sont alignées les unes avec les autres dans la direction des colonnes de sorte que les capacités correspondant aux longueurs des couches de câblage de rangées sont les mêmes.

2. Dispositif à circuit intégré à semi-conducteur selon la revendication 1, comprenant en outre :
une couche de câblage de colonnes de cellules (32) supplémentaire pour interconnecter lesdites bornes de sortie desdites cellules d'amplification de signal.

3. Dispositif à circuit intégré à semi-conducteur selon la revendication 1 ou 2, dans lequel lesdites cellules de réglage de capacité de charge sont situées aux extrémités desdites rangées de cellules.
